# EUROPÄISCHE PATENTSCHRIFT

(11) **EP 0 432 451 B1**
(45) Veröffentlichungstag und Bekanntmachung des Hinweises auf die Patenterteilung: **02.01.1997**
(21) Anmeldenummer: 90121283.7
(22) Anmeldetag: 07.11.1990
(51) Int. Cl.: G03F 7/32

(54) **Entwicklerkonzentrat und daraus hergestellter Entwickler für belichtete negativ arbeitende Reproduktionsschichten sowie Verfahren zur Herstellung von Druckformen**
Developer concentrate and developer therefrom for negative working printing plates with overcoat; method for producing printing plates
Concentré de révélateur et révélateur pour des couches de reproduction négatives exposées avec couche de recouvrement; méthode de fabrication de plaques d'impression

(30) Priorität: 16.11.1989 DE 3938107
(43) Veröffentlichungstag der Anmeldung: 19.06.1991
(73) Patentinhaber: Agfa-Gevaert AG, D-51373 Leverkusen (DE)
(72) Erfinder: Joerg, Klaus, Dr. Dipl.-Chem., W-6507 Ingelheim (DE); Zertani, Rudolf, Dipl.Chem., W-6500 Mainz (DE)

(56) Entgegenhaltungen:
- EP-A- 0 080 042
- EP-A- 0 180 122
- EP-A- 0 301 264

## Beschreibung

Entwicklerkonzentrat und daraus hergestellter Entwickler für belichtete negativ arbeitende Reproduktionsschichten sowie Verfahren zur Herstellung von Druckformen

Die Erfindung betrifft ein mit Leitungswasser auf den gebrauchsfertigen Zustand verdünnbares Entwicklerkonzentrat, das zum Entwickeln von negativ arbeitenden, belichteten Reproduktionsschichten in Kopiermaterialien geeignet ist sowie ein Verfahren zur Herstellung von Druckformen.

Kopiermaterialien der genannten Art werden insbesondere bei der Herstellung von Druckplatten oder von Photoresists verwendet und bestehen aus einem Schichtträger und einer negativ arbeitenden, lichtempfindlichen Reproduktionsschicht. Als Schichtträger werden in diesen Kopiermaterialien Metalle wie Zink, Chrom, Kupfer, Messing, Stahl, Aluminium oder Kombinationen dieser Metalle, Kunststoffolien, Papier oder ähnliche Materialien verwendet. Diese Schichtträger können ohne eine modifizierende Vorbehandlung, bevorzugt aber nach Durchführung einer Oberflächenmodifizierung, wie einer mechanischen, chemischen oder elektrochemischen Aufrauhung, einer Oxidation und/oder einer Behandlung mit Hydrophilierungsmitteln (z. B. bei Offsetdruckplatten-Trägern), mit der lichtempfindlichen Reproduktionsschicht beschichtet werden. Diese Reproduktionsschichten enthalten wasserunlösliche Diazoniumsalz-Polykondensationsprodukte.

Neben der lichtempfindlichen Komponente können die Reproduktionsschichten auch noch Weichmacher, Pigmente, Farbstoffe, Netzmittel, Sensibilisatoren, Indikatoren und andere übliche Hilfsmittel enthalten. Ausführlich werden solche Reproduktionsschichten beispielsweise in der DE-A 20 65 732 (= US-A 3 867 147) beschrieben.

Bisher bekannte Entwickler bzw. Entwicklergemische weisen insbesondere folgende Nachteile auf:
- Sie enthalten oftmals höhere Anteile an organischem Lösemittel, die aus ökologischen Gründen (niedrigsiedend, feuergefährlich, unangenehm riechend, negative Beeinflussung von Abwasser und Abluft, aufwendige Vorkehrungen zur Beseitigung der Lösemittel nach der Entwicklung) möglichst nicht mehr in zeitgemäßen Entwicklern vorhanden sein sollten.
- Das in der Praxis bisher oftmals eingesetzte Laurylsulfat oder andere Alkansulfate oder Alkansulfonate sind zwar an sich wirksame Entwicklerkomponenten für die angegebenen lichtempfindlichen Reproduktionsschichten, sie erfordern aber eine verhältnismäßig lange Entwicklungszeit, sie schäumen in Verarbeitungsmaschinen zu stark, insbesondere bei Vertikalentwicklung, und die Löslichkeit bei niedrigen Temperaturen (z. B. ab etwa 10°C und tiefer) in Wasser sinkt in einem Ausmaß, daß bei herbstlichen oder winterlichen Temperaturen flockige Rückstände in den Stammlösungen anfallen können, die für den Verarbeiter oftmals störend sind. Fettflecken und Klebstoffreste, wie sie bei der Handhabung von Offsetdruckplatten unter Praxisbedingungen auftreten können, werden von diesen Entwicklerkomponenten höchstens nach langer Einwirkzeit und durch zusätzliche mechanische Hilfen entfernt.
- Sie sind häufig zwar bei Anwendung für die speziellen Reproduktionsschichten, für die sie entwickelt wurden, und bei denen sie in den jeweiligen Beispielen auch erfolgreich eingesetzt wurden, auch geeignet, zeigen aber bei von diesen speziellen Reproduktionsschichten verschiedenen Schichten mehr oder weniger große Schwierigkeiten; d. h. sie sind nicht universell einsetzbar.
- Sie sind nicht geeignet, generell die in vielen Fällen, hauptsächlich bei maschineller Entwicklung, auftretenden Verunreinigungen (Fladen und Fädchen), die sich als Redeponierungen auf den Druckformen ablagern, zu unterbinden, so daß keine optimale Qualität des Endproduktes - auch bei längerem Gebrauch des Entwicklers - erreicht werden kann.

In der DE-A 34 39 597 (= US-A 4 716 098) ist ein Entwicklergemisch beschrieben, das sich vom oben beschriebenen Stand der Technik abgrenzt, dessen Nachteile nicht aufweist und zur Entwicklung von Flachdruckplatten geeignet ist. Die dort beschriebenen Schichten enthalten ein Diazoniumsalz-Polykondensationsprodukt und ein im Alkalischen lösliches carboxylgruppenhaltiges Bindemittel. Es ist aber nur in sehr verdünnter Form stabil und liegt deshalb nur in verdünnter, wäßriger Lösung vor. Der beschriebene Entwickler enthält bis zu 85 % Wasser, wodurch unnötig große Gebinde vonnöten sind, die zudem negative Auswirkungen auf Transport und Applikation haben.

In der EP-A 080 042 ist ein Entwickler zur Entfernung der unbelichteten Bereiche negativ-arbeitender, lichtempfindlicher Beschichtungen, die ein hochmolekulares Polymer enthalten, offenbart. Der Entwickler umfaßt neben Wasser ein anionisches oberflächenaktives Mittel, ein organisches Lösemittel, ein alkalisch reagierendes sowie ein wasserenthärtendes Mittel (d.h. ein Komplexbildner für Calcium- und Magnesium-Ionen).

Es stellte sich somit die Aufgabe, ein Konzentrat eines Entwicklers für negativ arbeitende, belichtete Reproduktionsschichten herzustellen, das
- einen hohen Feststoffgehalt aufweist und auch nach einem eventuellen Einfrieren keine Ausfällungen, Phasentrennungen oder Trübungen beim Wiederauftauen zeigt,
- bei Bedarf vor der Anwendung in der Druckerei mit Ca- und Mg-ionenhaltigem Wasser, insbesondere Leitungswasser, auf das in der Praxis erforderliche Maß verdünnt werden kann, ohne daß sich dabei Ausfällungen zeigen,
- , um in automatischen Verarbeitungsanlagen eingesetzt werden zu können, schnell entwickelt und dabei ebenso optimale Entwicklungseigenschaften (gute Auflösung der Nichtbildstellen und Nichtangriff der Bildstellen) aufweist,
- sowohl als Konzentrat als auch in den verschiedenen Verdünnungsgraden ohne Fladen- und Fädchenbildung entwickelt und dabei eine hohe Ergiebigkeit aufweist, d. h. auch über einen längeren Zeitraum in seinem Entwicklungsverhalten brauchbar ist, ohne Verunreinigungen zu bilden, und
- sowohl bei bindemittelhaltigen als auch bei bindemittelfreien Systemen verwendet werden kann.

Ausgehend von den Beispielen der DE-A 34 39 597 wurde versucht, ein Konzentrat herzustellen, indem bei den dort genannten Entwicklergemischen ein Teil des Wassers nicht zugesetzt wurde. Es zeigte sich jedoch, daß sich die Komponenten aller Beispiele nicht mehr homogen lösen sowie Phasentrennungen erfolgen oder Ausfällungen beim Einfrieren auftreten, die auch nach dem Auftauen nicht mehr reversibel sind.

Gelöst wird die Aufgabe durch ein Entwicklerkonzentrat, bestehend aus einem Gemisch aus Wasser,
- 1,0 bis 15 Gew.-%: eines organischen Lösemittels,
- 1,5 bis 8,0 Gew.-%: eines Alkalimetallhydroxids,
- 1,0 bis 15 Gew.-%: eines anionischen Tensids,
- 1,0 bis 16 Gew.-%: einer n-Alkansäure und/oder deren Salze,
- 0,1 bis 10 Gew.-%: eines Emulgators,
- 0,5 bis 20 Gew.-%: einer Puffersubstanz und
- 0,5 bis 9,0 Gew.-%: eines Komplexbildners, der ein Alkalisalz eines oligomeren Phosphats mit 2 bis 10 Phosphoreinheiten und/oder der N-(2-Hydroxy-ethyl)ethylendiaminotriessigsäure ist,
das sich mit Leitungswasser im Verhältnis 1:0,5 bis 1:3 zu einem Entwickler zum Entwickeln einer auf einem Träger befindlichen negativ arbeitenden belichteten Reproduktionsschicht verdünnen läpt.

Wenn auch die Komponenten des Entwicklerkonzentrates einzeln oder auch in teilweiser Kombination aus dem Stand der Technik bekannt sind, so ist es dennoch überraschend, daß durch die Wahl des erfindungsgemäßen Komplexbildners Entwicklerkonzentrate erhalten werden, die keine Ausfällungen oder Phasentrennungen zeigen; auch dann nicht, wenn das Konzentrat mehrere Male eingefroren und wieder aufgetaut wurde.

Als Komplexbildner werden die Salze niedermolekularer Phosphate, sogenannte Oligophosphate, mit 2 bis 10, insbesondere 2 bis 6, vorzugsweise 2 bis 4, Phosphoreinheiten, eingesetzt. Besonders bevorzugt sind die Alkalisalze, insbesondere die Natriumsalze. Zu nennen sind Tetranatriumdiphosphat, Pentanatriumtriphosphat und Hexanatriumtetraphosphat.

Ebenso werden die Alkalisalze, insbesondere das Natriumsalz der N-(2-Hydroxyethyl)-ethylendiaminotriessigsäure, verwendet. Diese können allein oder in Kombination mit den niedermolekularen Phosphaten eingesetzt werden. Besonders bevorzugt sind jedoch Entwickler, die entweder ein niedermolekulares Phosphat oder das Natriumsalz der genannten Triessigsäure enthalten.

Der Gehalt an dem Komplexbildner im Entwicklerkonzentrat beträgt 0,1 bis 9,0 Gew.-%, insbesondere 0,5 bis 6,0 Gew.-% und vorzugsweise 2,0 bis 6,0 Gew.-%. Sofern das Alkalisalz der N-(2-Hydroxyethyl)-ethylendiaminotriessigsäure im Entwicklerkonzentrat enthalten ist, liegt dessen bevorzugter Gehalt bei 2,0 bis 5,0 Gew.-%.

Das erfindungsgemäße Entwicklerkonzentrat enthält ferner n-Alkansäuren und/oder deren Salze mit 8 bis 12 Kohlenstoffatomen. Besonders gute Ergebnisse werden mit Capryl-, Pelargon-, Caprin- und Laurinsäure erzielt. Im Entwicklerkonzentrat liegen diese Säuren in einem Gehalt von 1,0 bis 16,0 Gew.-%, insbesondere 1,5 bis 14,0 Gew.-%, vor.

Als Tenside kommen viele anionische oberflächenaktive Mittel in Frage. Insbesondere haben sich vor allem solche bewährt, die aus der Gruppe Alkali-, vorzugsweise Natrium-, -octylsulfate, -dodecylbenzolsulfonat, -alkylphenolethersulfate, -naphthalensulfonate, -sulfosuccinate, -alkyletherphosphate oder Alkali-, vorzugsweise Natrium-ölsäuremethyltaurid ausgewählt sind. Das oder die anionische(n) oberflächenaktive(n) Mittel liegen im Entwicklerkonzentrat mit 0,2 bis 15,0 Gew.-%, insbesondere mit 1,0 bis 10,0, Gew.-%, vorzugsweise mit 1,0 bis 8,0 Gew.-%, vor.

Als Emulgatoren werden hauptsächlich Produkte eingesetzt, die aus der Gruppe Poly-N-vinyl-N-methylacetamid, wasserlösliche Copolymere des N-Vinyl-N-methylacetamid, Polyvinylalkohol, Dextrin, Gummi arabicum und Celluloseether, insbesondere Carboxymethylcellulose, ausgewählt sind. Der bevorzugte Gehalt an Emulgator im Entwicklerkonzentrat beträgt 0,1 bis 10,0 Gew.-%, insbesondere 0,2 bis 6,0 Gew.-%, vorzugsweise 1,0 bis 5,0 Gew.-%.

Zahlreiche bekannte organische Lösemittel können Verwendung finden, jedoch haben sich besonders solche in der Praxis bewährt, die aus der Gruppe Benzylalkohol, Ethylenglykolmonophenylether, 1-Phenylethanol, 2-Phenylethanol und Propylenglykolmonomethyl- und phenylether ausgewählt sind. Der Anteil an organischem Lösemittel im Entwicklerkonzentrat liebt zweckmäßig bei 0,5 bis 15,0 Gew.-%, insbesondere bei 1,0 bis 10,0, Gew.-%, vorzugsweise bei 5,0 bis 10,0 Gew.-%.

Als puffernde Systeme sind grundsätzlich alle diejenigen geeignet, die vorzugsweise im pH-Bereich von 8 bis 12 wirksam sind. Vor allem werden jedoch die allgemein zugänglichen Puffersubstanzen aus der Gruppe Carbonate, Phosphate, Borate, Alkalisalze des Glycins und Amine, dabei vorzugsweise Diethanolamin und Triethanolamin, verwendet. Sehr gebräuchliche Puffersysteme sind beispielsweise Mischungen aus Carbonat/Hydrogencarbonat, Phosphat/Hydrogenphosphat u.ä. Der Gehalt an Puffersubstanz im Entwicklungkonzentrat liegt bei 0,5 bis 20,0 Gew.-%, vorzugsweise bei 0,7 bis 10,0 Gew.-%.

Als alkalisch reagierende Mittel werden vorwiegend Alkalimetallhydroxide, insbesondere LiOH, NaOH und KOH verwendet. Der Anteil an diesem Mittel im Entwicklerkonzentrat liegt bei 1,5 bis 8,0 Gew.-%, insbesondere bei 1,5 bis 6,0 Gew.-% und vorzugsweise bei 1,0 bis 5,0 Gew.-%.

Dadurch, daß nur relativ geringe Anteile an organischem Lösemittel im Entwicklergemisch vorhanden sind, ändert dieses seine Zusammensetzung während des Gebrauchs praktisch nicht und hat somit in den Entwicklungsvorrichtungen eine verhältnismäßig lange Standzeit.

Im allgemeinen liegt der pH-Wert der erfindungsgemäßen Entwicklerkonzentrate vorzugsweise bei 8 bis 12.

Die erfindungsgemäßen Entwicklerkonzentrate zeigen keine störende Geruchsbelästigung, und es treten auch bei Temperaturen um den Gefrierpunkt im beanspruchten Mengenbereich der Komponenten keine Ausfällungen auf.

Klebstoffreste (z. B vom Aufkleben der Filmvorlagen beim Kopieren) und Fettflecken (z.B. vom stanzen der Druckplatten) lassen sich mühelos auch bei geringerer Einwirkzeit des Entwicklers entfernen. Die Entwicklungsgeschwindigkeit ist gegenüber herkömmlichen Entwicklern erhöht, ohne daß eine Verringerung der Entwicklerresistenz der Bildbereiche zu beobachten ist. Auch die Salze der Alkansäuren können als kürzerkettige "Seifen" verhältnismäßig leicht abgebaut werden. Eine Fladen- oder Fädchenbildung, die zu einer unerwünschten Verunreinigung des Fertigproduktes und der Verarbeitungsanlage führt, ist nicht zu beobachten.

Neben den genannten vorteilhaften Eigenschaften ist es insbesondere überraschend, daß auch das Konzentrat stets homogen bleibt, selbst nachdem es längere Zeit eingefroren war und wieder aufgetaut wurde.

Ein weiterer Vorteil besteht darin, daß das erfindungsgemäße Entwicklerkonzentrat erst beim Kunden auf das notwendige Maß verdünnt werden muß. Dabei kann auch stark Ca- und Mg-ionenhaltiges Wasser verwendet werden, ohne daß es zu Ausfällungen kommt. Die konzentrierte Form hat den zusätzlichen Vorteil, daß das Transportvolumen kleiner ist und deshalb die Transportkosten niedriger sind. Dies ist insbesondere bei Exportartikeln relevant.

Das erfindungsgemäße Entwicklerkonzentrat ist grundsätzlich für die meisten der negativ arbeitenden Reproduktionsschichten, wie sie zum Stand der Technik gehören, verwendbar. Zum Verdünnen des Konzentrats zum gebrauchsfertigen Entwickler für eine auf einem Träger befindliche negativ arbeitende, belichtete Reproduktionsschicht kann einfaches Leitungswasser, das insbesondere Ca- und Mg-Ionen enthält, verwendet werden. Das Verdünnungsverhältnis von Konzentrat zu Leitungswasser liegt im Bereich von 1:0,5 bis 1:3, vorzugsweise bei 1:1 bis 1:2.

Die zu entwickelnden Reproduktionsschichten können sowohl die bekannten Bindemittel enthalten als auch bindemittelfrei sein. Bevorzugt wird das Entwicklerkonzentrat jedoch bei bindemittelhaltigen Reproduktionsschichten eingesetzt. Als lichtempfindliche Komponenten enthalten solche Reproduktionsschichten insbesondere Diazoniumsalz-Polykondensationsprodukte.

Als Diazoniumsalz-Polykondensationsprodukte sind kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R⁸-R⁹-)ₚR¹⁰-N₂X ab, wobei
- X: das Anion der Diazoniumverbindung,
- p: eine ganze Zahl von 1 bis 3,
- R⁸: einen aromatischen Rest mit mindestens einer zur Kondensation mit aktiver Carbonylverbindung befähigten Position,
- R¹⁰: eine Phenylengruppe,
- R⁹: eine Einfachbindung oder eine der Gruppen:

-(CH₂)_{q}-NR¹¹-, O-R¹²-O,

-O-(CH₂)ᵣ-NR¹¹-, -O-,

-S-(CH₂)ᵣ-NR¹¹-, -S-

oder

-S-CH₂CO-NR¹¹-, -CO-NR¹¹-
bedeuten, worin
- q: eine Zahl von 0 bis 5,
- r: eine Zahl von 2 bis 5,
- R¹¹: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R¹²: eine Arylengruppe mit 6 bis 12 C-Atomen ist.

Die mit dem Entwickler entwickelbaren Gemische enthalten im allgemeinen 5 bis 90, bevorzugt 10 bis 70 Gew.-% Diazoniumverbindung.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74l60), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Ebenso können photopolymerisierbare Verbindungen als lichtempfindliche Verbindungen verwendet werden. Die diese Verbindungen enthaltenden Schichten weisen als wesentliche Bestandteile ein polymeres Bindemittel, eine radikalisch polymerisierbare Verbindung mit mindestens einer, bevorzugt mindestens zwei endständigen, ethylenisch ungesättigten Gruppen sowie einen durch aktinisches Licht aktivierbaren Polymerisationsinitiator bzw. eine Initiatorkombination auf.

Der aus dem erfindungsgemäßen Entwicklerkonzentrat hergestellte Entwickler ist anwendbar für solche photopolymerisierbaren Schichten, die keine Deckschicht enthalten.

Geeignet sind polymerisierbare Verbindungen, die in den US-A 2 760 863 und 3 060 023 beschrieben werden.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkololen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Ebenso können polymerisierbare Verbindungen, die mindestens eine photooxidierbare und ggf. mindestens eine Urethangruppe im Molekül enthalten, verwendet werden.

Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt. Ebenso sind die in der älteren deutschen Patentanmeldung P 38 25 836.6 beschriebenen Verbindungen mit photooxidierbaren Gruppen anwendbar.

Als Photoinitiatoren können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Bevorzugt werden als Photoinitiatoren photoreduzierbare Farbstoffe, insbesondere in Kombination mit durch Belichtung spaltbaren Trihalogenmethylverbindungen und gegebenenfalls mit als Photoinitiatoren wirksamen Acridin-, Phenazin- oder Chinoxalinverbindungen, wie sie in den DE-A 37 10 281 und 37 10 282 beschrieben sind.

Geeignete photoreduzierbare Farbstoffe sind insbesondere Xanthen-, Benzoxanthen-, Benzothioxanthen-, Thiazin-, Pyronin, Porphyrin- oder Acridinfarbstoffe. Die Menge des Farbstoffs liegt im allgemeinen zwischen 0,01 und 10, vorzugsweise zwischen 0,05 und 4 Gew.-%, bezogen auf die nichtflüchtigen Bestandteile der Schicht.

Zur Steigerung der Lichtempfindlichkeit können den Schichten Verbindungen mit photolytisch spaltbaren Trihalogenmethylgruppen, die als radikalbildende Photoinitiatoren für photopolymerisierbare Gemische an sich bekannt sind, zugesetzt werden. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 21 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet.

Diese Komponenten werden im allgemeinen in einer Menge von 0,01 bis 10, vorzugsweise von 0,05 bis 6 Gew.-%, bezogen auf die nichtflüchtigen Bestandteile der Schicht, eingesetzt.

Die Schichten enthalten vorzugsweise als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Die Menge dieser Komponente liegt ebenfalls im Bereich von 0,01 bis 10 Gew.-%, vorzugsweise zwischen 0,05 und 5 Gew.-%.

Wenn eine weitere Empfindlichkeitssteigerung im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Die Menge dieser Verbindung liegt ebenfalls im bereich von 0,01 bis 10, vorzugsweise von 0,05 bis 4 Gew.-%.

Die Gesamtmenge an Polymerisationsinitiatoren liegt im allgemeinen bei 0,05 bis 20, vorzugsweise bei 0,1 bis 10 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in den für den Initiierungsvorgang wichtigen aktinischen Strahlungsbereich möglichst wenig absorbieren.

Der aus dem erfindungsgemäßen Konzentrat erhältliche Entwickler ist ebenso geeignet für das Entwickeln von negativ arbeitenden, lichtempfindlichen Schichten, die sowohl ein Diazoniumsalz-Polykondensationsprodukt als auch eine photopolymerisierbare Verbindung enthalten.

Als Bindemittel in den beschriebenen lichtempfindlichen Schichten werden solche bevorzugt, die seitenständige Carboxylgruppen aufweisen. Besonders geeignet sind Bindemittel, die in Wasser unlöslich, in organischen Lösemitteln löslich und in wäßrig-alkalischen Lösungen löslich oder zumindest quellbar sind. Solche Bindemittel sind in den US-A 2 861 058, DE-A 31 30 987, 34 04 366 und der älteren deutschen Patentanmeldung P 38 25 836.6 beschrieben. Als Carboxylgruppen enthaltende Bindemittel kommen insbesondere Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen in Frage.

Die vorstehend genannten Polymeren sind insbesondere dann geeignet, wenn sie ein Molekulargewicht zwischen 500 und 200 000 oder darüber, bevorzugt 1 000 bis 100 000, und eine Säurezahl zwischen 10 und 250, bevorzugt zwischen 20 und 200, aufweisen.

Als bevorzugte alkalilösliche Bindemittel seien erwähnt: Copolymerisate der (Meth)acrylsäure mit Alkyl(meth)acrylaten, (Meth)acrylsäurenitril oder dgl., Copolymerisate der Crotonsäure mit Alkyl(meth)acrylaten, (Meth)acrylsäurenitril oder dgl., Copolymerisate der Vinylessigsäure mit Alkyl(meth)acrylaten, Umsetzungsprodukte von intramolekularen Anhydriden organischer Polycarbonsäuren oder von Propenylsulfonylisocyanat mit hydroxylgruppenhaltigen Polymeren, die keine weiteren, zur Umsetzung mit Säureanhydriden oder Isocyanaten befähigten funktionellen Gruppen enthalten, Copolymerisate des Maleinsäureanhydrids mit ggf. substituierten Styrolen, ungesättigten Kohlenwasserstoffen, ungesättigten Ethern oder Estern und Veresterungsprodukte (bzw. Teilveresterungsprodukte) der Copolymerisate des Maleinsäureanhydrids. Die Menge des Bindemittels im lichtempfindlichen Gemisch beträgt im allgemeinen 20 bis 90 Gew.-%, vorzugsweise 40 bis 80 Gew.-%.

Mit dem aus dem erfindungsgemäßen Konzentrat hergestellten Entwickler entwickelbar sind: Aufzeichnungsschichten für die photomechanische Herstellung von Druckformen für den Hochdruck, Flachdruck, Tiefdruck und Siebdruck, von Reliefkopien, z. B. Herstellung von Texten in Blindenschrift, von Einzelkopien, Gerbbildern, Pigmentbildern usw.. Besondere Bedeutung haben die Aufzeichnungsschichten für die Herstellung von Flachdruckplatten und für die Photoresisttechnik.

Als Schichtträger für das entwickelbare Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Die Belichtung des mit dem Entwickler entwickelbaren Aufzeichnungsmaterials kann mit allen dem Fachmann geläufigen Lichtquellen erfolgen, z.B. mit Röhren-, Xenonimpuls-, metallhalogeniddotierte Quecksilberdampf-Hochdruck- und Kohlenbogenlampen. Darüber hinaus ist das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke der vorliegenden Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen.

Die Erfindung betrifft auch ein Verfahren zur Herstellung einer Druckform, wobei man auf einen Träger, vorzugsweise aus Aluminium oder dessen Legierungen, der insbesondere mechanisch und/oder chemisch und/oder elektrochemisch vorbehandelt und/oder hydrophiliert ist, eine negativ arbeitende, gegebenenfalls Diazoniumsalze und/oder gegebenenfalls Bindemittel enthaltende Reproduktionsschicht aufbringt, die Schicht bildmäßig belichtet und anschließend mit einem Entwickler, der durch Verdünnen des erfindungsgemäßen Konzentrats mit Wasser hergestellt wird, entwickelt.

Im Folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiel 1

Eine elektrochemisch aufgerauhte, anodisch oxidierte und mit einer wäßrigen Lösung von Polyvinylphosphonsäure behandelte Aluminiumfolie in Plattenform wird mit einer Lösung aus
- 62 Gt: eines Polymeren, hergestellt durch Rückflußerhitzung unter Verwendung eines Polyvinylbutyrals mit einem Molekulargewicht von etwa 70.000 bis 80.000, das 71 % Vinylbutyral-, 2 % Vinylacetat- und 27 % Vinylalkoholeinheiten, Maleinsäureanhydrid, Methylethylketon und Trimethylamin enthält,
- 21 Gt: eines Diazoniumsalz-Polykondensationsproduktes, hergestellt aus 1 mol 3-Methoxy-diphenyl-amin-4-diazoniumsulfat und 1 mol 4,4′-Bismethoxymethyl-diphenylether in 85%iger Phosphorsäure und isoliert als Mesitylensulfonat,
- 2,5 Gt: Phosphorsäure (85 %),
- 3 Gt: Viktoriareinblau FGA (C.I.Basic Blue 81) und
- 0,6 Gt: Phenylazodiphenylamin in
- 2570 Gt: Ethylenglykolmonomethylether und
- 780 Gt: Tetrahydrofuran
beschichtet.

Die so erhaltene Kopierschicht, die nach dem Trocknen ein Schichtgewicht von 0,95 g/m² aufweist, wird unter einer Negativvorlage 30 s mit einer Metallhalogenid-Lampe von 5 kW Leistung belichtet und mit den Entwicklerkonzentraten der unten aufgeführten Beispiele 2 bis 25, die zuvor mit Leitungswasser im angegebenen Verhältnis verdünnt worden sind, problemlos entwickelt. Keines der Konzentrate zeigt Trübungen, Ausfällungen oder Phasentrennungen, auch nicht nach mehrmaligem Einfrieren und Wiederauftauen.

Ebenso werden bei keinem der verdünnten Konzentrate Trübungen oder Ausfällungen beobachtet. Die Entwicklungszeiten sind praxisgerecht, wobei die Nichtbildstellen sauber entwickelt sind. Eine Fladen- oder Fädchenbildung ist nicht zu beobachten. Auch beim Einsatz der verdünnten Entwicklerkonzentrate in einer üblichen Maschine zum Entwickeln und Herstellen einer Druckform mit Zwischenspülung und Gummierung sind keine entsprechenden Störungen festzustellen. Von der entwickelten Platte lassen sich in einer Offsetdruckmaschine mehrere Tausend einwandfreie Drucke anfertigen.

### Beispiele 2 bis 25

In den folgenden Tabellen I und II sind die jeweiligen Entwicklerkonzentrate zusammengestellt. Das Konzentrat wird hergestellt, indem man die Flüssig- und Festbestandteile entsprechend ihrem angegebenen Gehalt zu der Menge entionisiertem Wasser gibt, die sich aus der Differenz zwischen 100 Gew.-% und der Summe aller Flüssig- und Festbestandteile ergibt. Zunächst werden hierbei die Flüssigkeiten und dann die Feststoffe unter Rühren zugegeben.

Nachdem alles gelöst ist, wird das Konzentrat filtriert. Zum Entwickeln werden die erhaltenen Konzentrate im angegeben Verhältnis mit Wasser, insbesondere Leitungswasser, verdünnt. Die genannten Reproduktionsschichten des Beispiels 1 sowie die Schichten A bis E können mit diesen Entwicklergemischen problemlos entwickelt werden.

**Tabelle I**

| | Zusammensetzung des Entwicklerkonzentrats in Gewichtsprozent | | | | | | | | | | | |
|---|---|---|---|---|---|---|---|---|---|---|---|---|
| Beispiel | 2 | 3 | 4 | 5 | 6 | 7 | 8 | 9 | 10 | 11 | 12 | 13 |
| Pelargonsäure | 8 | 8 | 8 | 7 | 7 | 8,1 | 8,1 | 8,1 | 12,8 | 7,3 | 7,3 | 8 |
| Octylsulfat | - | - | - | 6 | 6 | - | - | - | 6,4 | - | - | - |
| Propylenglycolmonophenylether | - | - | - | - | - | 8 | 8 | 8 | - | - | - | - |
| K₂B₄O₇ x 4H₂O | - | - | 2 | 2 | 2 | 2 | 2 | 2 | 3,2 | 2,5 | 2,5 | 2 |
| KOH fest | 2,8 | 2,8 | 2,8 | 2,5 | 2,5 | 2,8 | 2,8 | 2,8 | 4,5 | 2,6 | 2,6 | 2,8 |
| Glycin-K-Salz | 3,2 | 3,2 | - | - | - | - | - | - | - | - | - | - |
| Poly-N-vinyl-N-methylacetamid | 4 | 4 | 4 | 1 | 1 | 1 | 1 | 1 | - | 2,1 | 2,1 | 1 |
| Dodecylbenzolsulfonsäure / Na-Salz | 2,6 | 2,6 | 2,6 | - | - | 2,6 | 2,6 | 2,6 | - | 1,4 | 1,4 | 2 |
| Ethylenglycolmonophenylether | 6 | 6 | 6 | 6 | 6 | - | - | - | 9,6 | 6,3 | 6,3 | 8 |
| Pentanatriumtriphosphat | - | 6 | 5 | - | 4,1 | 3,3 | - | - | 4,8 | 3,8 | - | 4 |
| N-(2-Hydroxyethyl)-ethylendiaminotriessigsäure Na-Salz | 3 | - | - | 4 | - | - | 3 | - | - | - | 4 | - |
| Hexanatriumtetraphosphat | - | - | - | - | - | - | - | 3,3 | - | - | - | - |
| Entwicklerkonzentrat:entionisiert. Wasser | ad 100 % | | | | | | | | | | | |
| Entwickler: Verdünnungsverhältn. Wasser : Konzentrat | 1:1 | | | | | | | | 2:1 | 1:1 | | |

**Tabelle II**

| | Zusammensetzung des Entwicklerkonzentrats in Gewichtsprozent | | | | | | | | | | | |
|---|---|---|---|---|---|---|---|---|---|---|---|---|
| Beispiel | 14 | 15 | 16 | 17 | 18 | 19 | 20 | 21 | 22 | 23 | 24 | 25 |
| Ethylenglycolmonophenylether | 7,9 | 7,9 | 7,9 | 6,5 | 6,5 | 6,5 | 6,5 | 8,0 | 6 | 6 | 6 | 6 |
| Octylsulfat | 7,9 | 7,9 | 7,9 | - | - | - | - | - | 4 | 4 | 4 | 4 |
| KOH fest | 2,4 | 2,4 | 2,4 | 3 | 3 | 3 | 3 | 2,8 | 2 | 2 | 2 | 2 |
| Pelargonsäure | 6,9 | 6,9 | 6,9 | 8,6 | 8,6 | 8,6 | 8,6 | 8,1 | 8 | 8 | 8 | 8 |
| Triethanolamin | 2 | 2 | 2 | 6,5 | 6,5 | 6,5 | 6,5 | - | - | - | - | - |
| Poly-N-vinyl-N-methylacetamid | - | - | - | 4,3 | 2 | 4,3 | 4,3 | 1 | 4 | 4 | 4 | 1,3 |
| K₂B₄O₇ x 4H₂O | - | - | - | - | - | - | - | 2 | - | - | - | - |
| Dodecylbenzolsulfonsäure / Na-Salz | - | - | - | - | - | - | - | 2,6 | - | - | - | - |
| K₂CO₃ | - | - | - | - | - | - | - | - | 3 | 3 | 3 | 3 |
| KHCO₃ | - | - | - | - | - | - | - | - | 3 | 3 | 3 | 3 |
| N-(2-Hydroxyethyl)-ethylendiaminotriessigsäure/Na-Salz | - | - | 3 | - | 3 | - | 3 | - | - | - | - | 3 |
| Tetranatrium - diphosphat | - | - | - | - | - | - | - | 3 | - | 2 | - | - |
| Pentanatriumtriphosphat | 3,3 | - | - | - | - | 4,3 | - | - | - | - | 4 | - |
| Hexanatriumtetraphosphat | - | 4 | - | 4 | - | - | - | - | 4 | - | - | - |
| Entwicklerkonzentrat:entionisiert. Wasser | ad 100 % | | | | | | | | | | | |
| Entwickler: Verdünnungsverhältnis Wasser : Konzentrat | 1 : 1 | | | | | | | | | | | |

### Vergleichsbeispiele

Ausgehend von der DE-A 34 39 597 wird bei einigen der dort angegebenen Beispiele durch Weglassen von Wasser versucht, die Gemische zu konzentrieren. Die Menge an Wasser wird so gewählt, daß die in den Tabellen der DE-A 34 39 597 angegebenen Beispiele nicht auf 100 %, sondern auf 50 % mit Wasser aufgefüllt werden.

### Vergleichsbeispiel 1:

(Konzentrierung des Beispiels 7 der DE-A 34 39 597) Zu 33,0 Gt (= Gewichtsteile) entionisiertem Wasser werden unter Rühren 4,0 Gt Pelargonsäure, 3 Gt Ethylenglykolmonophenylether, 1 Gt Kaliumhydroxid, 2 Gt Dodecylbenzolsulfonsäure-Na-Salz, 1,5 Gt Kaliumcarbonat, 1,5 Gt Kaliumhydrogencarbonat, 2 Gt poly-N-vinyl-N-methylacetamid und 2 Gt Nitrilotriessigsäure hinzugefügt. Das Entwicklerkonzentrat bleibt auch nach längerem Rühren trübe und ist deshalb für die Entwicklung der angegebenen Druckschichten unbrauchbar.

### Vergleichsbeispiel 2:

(Konzentrierung des Beispiels 16 der DE-A 34 39 597) Zu 34,4 Gt (= Gewichtsteile) entionisiertem Wasser werden unter Rühren 4,0 Gt Pelargonsäure, 3,0 Gt Ethylenglykolmonophenylether, 1,4 Gt Kaliumhydroxid, 2 Gt Dodecylbenzolsulfonsäure-Na-Salz, 2 Gt Grahamsalz, 2 Gt Poly-N-vinyl-N-methylacetamid und 1,25 Gt Trinatriumphosphat hinzugefügt. Das Entwicklerkonzentrat ist zunächst klar. Nach Einfrieren (- 15 °C) und Wiederauftauen bilden sich jedoch zwei Phasen. Ein solch inhomogenes Konzentrat ist nicht mehr zur Entwicklung von Druckschichten geeignet.

Die in der DE-A 34 39 597 angegebenen Entwicklergemische sind zwar zur Aufentwicklung bindemittelhaltiger Negativschichten geeignet, sie lassen sich aber nicht, wie die vergleichsbeispiele zeigen, konzentrieren.

Zur Verdeutlichung der Anwendungsbreite der erfindungsgemäßen Entwicklerkonzentrate werden mit den in den Beispielen 2 bis 25 angegebenen Konzentraten weitere Reproduktionsschichten (A bis E), die aus den folgenden Lösungen hergestellt werden, mit Erfolg entwickelt:
- A) 1,5 Gt: Diazoniumsalz-Polykondensationsprodukt aus 3-Methoxy-diphenylamin-4-diazoniumsulfat und Formaldehyd,
- 1,5 Gt: Bindemittel aus einem Umsetzungsprodukt aus Polyvinylbutyral und Maleinsäureanhydrid,
- 0,1 Gt: Viktoriareinblau FGA (C.I. Basic Blue 81),
- 0,1 Gt: 85%ige Phosphorsäure und
- 96,8 Gt: Ethylenglykolmonomethylether.

Das Schichtgewicht nach dem Trocknen beträgt 0,8 g/m².
- B) 1,5 Gt: Styrol-Maleinsäureanhydrid-Copolymer-Halbester (Scripset 540 der Fa. Monsanto)
- 1,5 Gt: des Diazoniumsalz-Polykondensationsproduktes aus Beispiel 1,
- 0,1 Gt: 85%ige Phosphorsäure,
- 0,1 Gt: Viktoriareinblau FGA (C.I. Basic Blue 81) und
- 96,8 Gt: Ethylenglykolmonomethylether.

Das Schichtgewicht nach dem Trocknen beträgt 0,6 g/m².
- C)97,0 Gt: eines Polymeren, hergestellt durch Umsetzung aus 11,3 Gt des in Beispiel 1 genannten Polyvinylbutyrals in Tetrahydrofuran mit 5,11 Gt Propenylsulfonylisocyanat in Tetrahydrofuran,
- 48,3 Gt: des in Beispiel 1 genannten Diazoniumsalz-Polykondensationsproduktes,
- 4,8 Gt: 85%ige Phosphorsäure,
- 3,5 Gt: Viktoriareinblau FGA (C.I. Basic Blue 81),
- 1,6 Gt: Phenylazodiphenylamin in
- 3500 Gt: Ethylenglykolmonomethylether und
- 1036 Gt: Tetrahydrofuran.

Das Schichtgewicht nach dem Trocknen beträgt 0,73 g/m².
- D) 0,45 Gt: eines Copolymeren aus 82 % Methylmethacrylat und 18 % Methacrylsäure (Säurezahl 117),
- 1,05 Gt: eines Polymeren, hergestellt durch Rückflußerhitzung unter Verwendung eines Polyvinylbutyrals mit einem Molekulargewicht von etwa 70- bis 80.000, das 71 % Vinylbutyral, 2 % vinylacetat und 27 % Vinylalkoholeinheiten, Maleinsäureanhydrid, Methylethylketon und Trimethylamin enthält,
- 0,45 Gt: des Diazoniumsalz-Polykondensationsproduktes gemäß Beispiel 1,
- 0,04 Gt: 85%ige Phosphorsäure,
- 0,09 Gt: Viktoriareinblau FGA (C.I. Basic Blue 81),
- 1,5 Gt: Pentaerythrittetraacrylat/-triacrylat (techn. Gemisch),
- 0,007 Gt: Phenylazodiphenylamin,
- 0,12 Gt: 2-(4-Styryl-phenyl)-4,6-bis-trichlormethyl-s-triazin in
- 47,7 Gt: Ethylenglykolmonomethylether und
- 48,6 Gt: Butanon.

Das Schichtgewicht nach dem Trocknen beträgt 1,8 g/m².
- E) 2,0 Gt: eines teilweise mit Alkanol veresterten Styrol-Maleinsäureanhydrid-Mischpolymerisats mit einem mittleren Molekulargewicht von 20.000 und einer Säurezahl um 200,
- 2,0 Gt: eines Diurethans, hergestellt durch Umsetzung von Glycerindimethacrylat mit Hexamethylendiisocyanat,
- 0,125 Gt: 9-Phenylacridin,
- 0,05 Gt: eines blauen Farbstoffes, erhalten durch Kuppeln von 2,4-Dinitro-6-chlor-benzoldiazoniumsalz mit 2-Methoxy-5-acetamino-N-cyanoethyl-N-hydroxyethylanilin in
- 25,0 Gt: Butanon und
- 12,0: Gt Butylacetat.

Das Schichtgewicht nach dem Trocknen beträgt 3,7 g/m².

## Patentansprüche

1. Entwicklerkonzentrat, bestehend aus einem Gemisch aus
Wasser,
1,0 bis 15 Gew.-% eines organischen Lösemittels,
1,5 bis 8,0 Gew.-% eines Alkalimetallhydroxids,
1,0 bis 15 Gew.-% eines anionischen Tensids,
1,0 bis 16 Gew.-% einer n-Alkansäure und/oder deren Salze,
0,1 bis 10 Gew.-% eines Emulgators,
0,5 bis 20 Gew.-% einer Puffersubstanz und
0,5 bis 9,0 Gew.-% eines Komplexbildners, der ein Alkalisalz eines oligomeren Phosphats mit 2 bis 10 Phosphoreinheiten und/oder der N-(2-Hydroxy-ethyl)ethylendiaminotriessigsäure ist,
das sich mit Leitungswasser im Verhältnis 1:0,5 bis 1:3 zu einem Entwickler zum Entwickeln einer auf einem Träger befindlichen negativ arbeitenden belichteten Reproduktionsschicht verdünnen läßt.

2. Entwicklerkonzentrat nach Anspruch 1, dadurch gekennzeichnet, daß der Gehalt an Komplexbildner im Konzentrat 0,5 bis 6 Gew.-% beträgt.

3. Entwicklerkonzentrat nach Anspruch 1 oder 2, dadurch gekennzeichnet, daß der Komplexbildner das Alkalisalz eines oligophosphats mit 2 bis 6 Phosphoreinheiten ist.

4. Entwicklerkonzentrat nach Anspruch 1 oder 2, dadurch gekennzeichnet, daß der Komplexbildner das Natriumsalz der N-(2-Hydroxy-ethyl)ethylendiaminotriessigsäure ist.

5. Entwicklerkonzentrat nach einem der Ansprüche 1 bis 4, dadurch gekennzeichnet, daß die n-Alkansäure und/oder deren Salze 8 bis 12 Kohlenstoffatome aufweist/aufweisen.

6. Entwicklerkonzentrat nach einem der Ansprüche 1 bis 5, dadurch gekennzeichnet, daß der Gehalc an n-Alkansäure im Konzentrat 1,5 bis 14,0 Gew.-% beträgt.

7. Entwicklerkonzentrat nach einem der Ansprüche 1 bis 6, dadurch gekennzeichnet, daß die n-Alkansäure und/oder deren Salze ausgewählt sind aus der Gruppe Capryl-, Pelargon-, Caprin- und Laurinsäure.

8. Entwicklerkonzentrat nach einem der Ansprüche 1 bis 7, dadurch gekennzeichnet, daß der Gehalt an anionischem Tensid im Konzentrat 1,0 bis 8,0 Gew.-% beträgt.

9. Entwicklerkonzentrat nach einem der Ansprüche 1 bis 8, dadurch gekennzeichnet, daß wenigstens ein anionisches oberflächenaktives Mittel ausgewählt ist aus der Gruppe Alkali-, vorzugsweise Natrium-, -octylsulfat, -dodecylbenzosulfonat, -alkylphenolethersulfate, -naphthalensulfonate, -sulfosuccinate, -alkyletherphosphate oder Alkali-, vorzugsweise Natrium-ölsäuremethyltaurid.

10. Entwicklerkonzentrat nach einem der Ansprüche 1 bis 9, dadurch gekennzeichnet, daß der Gehalt an Emulgator im Konzentrat 0,2 bis 6,0 Gew.-% beträgt.

11. Entwicklerkonzentrat nach einem der Ansprüche 1 bis 10, dadurch gekennzeichnet, daß wenigstens ein Emulgator ausgewählt ist aus der Gruppe Poly-N-vinyl-N-methylacetamid, wasserlösliche Copolymere des N-Vinyl-N-methylacetamid, Polyvinylalkohol, Dextrin, Gummi arabicum und Celluloseether, insbesondere Carboxymethylcellulose.

12. Entwicklerkonzentrat nach einem der Ansprüche 1 bis 11, dadurch gekennzeichnet, daß der Gehalt an organischem Lösemittel im Konzentrat 1,0 bis 10,0 Gew.-% beträgt.

13. Entwicklerkonzentrat nach einem der Ansprüche 1 bis 12, dadurch gekennzeichnet, daß wenigstens ein organisches Lösemittel ausgewählt ist aus der Gruppe Benzylalkohol, Phenoxyethanol, 1-Phenylethanol, 2-Phenylethanol und Propylenglykolmonomethyl- und -phenylether.

14. Entwicklerkonzentrat nach einem der Ansprüche 1 bis 13, dadurch gekennzeichnet, daß der Gehalt an Puffersubstanz im Konzentrat 0,7 bis 10,0 Gew.-% beträgt.

15. Entwicklerkonzentrat nach einem der Ansprüche 1 bis 14, dadurch gekennzeichnet, daß die Puffersubstanz ausgewählt ist aus der Gruppe Carbonate, Phosphate, Borate, Alkalisalze des Glycins und Amine, vorzugsweise Diethanolamin und Triethanolamin.

16. Verfahren zur Herstellung einer Druckform, wobei man auf einen Träger eine negativ arbeitende, Diazoniumsalz-Polykondensationsharz enthaltende Reproduktionsschicht aufbringt, die Schicht bildmäßig belichtet und anschließend mit einem Entwickler entwickelt, der aus dem Konzentrat nach einem der Ansprüche 1 bis 15 durch Verdünnen hergestellt ist.

17. Verfahren zur Herstellung einer Druckform, wobei man auf einen Träger eine negativ arbeitende, eine photopolymerisierbare Verbindung enthaltende Reproduktionsschicht aufbringt, die Schicht bildmäßig belichtet und anschließend mit einem Entwickler entwickelt, der aus dem Konzentrat nach einem der Ansprüche 1 bis 15 durch Verdünnen hergestellt ist.

18. Verfahren zur Herstellung einer Druckform, wobei man auf einen Träger eine negativ arbeitende, sowohl ein Diazoniumsalz-Polykondensationsharz als auch eine photopolymerisierbare Verbindung enthaltende Reproduktionsschicht aufbringt und gemäß Anspruch 16 weiterverfährt.

## Claims

1. A developer concentrate comprised of a mixture of water,
1.0 to 15 % b.w. of an organic solvent,
1.5 to 8.0 % b.w. of an alkali metal hydroxide,
1.0 to 15 % b.w. of an anionic surfactant,
1.0 to 16 % b.w. of an n-alkanoic acid and/or the salts thereof,
0.1 to 10 % b.w. of an emulsifier,
0.5 to 20 % b.w. of a buffering substance, and
0.5 to 9.0 % b.w. of a complexing agent which is an alkali metal salt of an oligomeric phosphate containing 2 to 10 phosphorus units and/or of N-(2-hydroxyethyl)-ethylenediaminotriacetic acid,
which can be diluted with tap water in a ratio of 1:0.5 to 1:3 to give a developer which is suitable for developing a negative-working, exposed reproduction layer applied to a support.

2. A developer concentrate as claimed in claim 1, wherein the content of complexing agent in the concentrate is 0.5 to 6.0 % by weight.

3. A developer concentrate as claimed in either of claims 1 or 2, wherein the complexing agent is the alkali-metal salt of an oligophosphate containing 2 to 6 phosphorus units.

4. A developer concentrate as claimed in either of claims 1 or 2, wherein the complexing agent is the sodium salt of N-(2-hydroxyethyl)ethylenediaminotriacetic acid.

5. A developer concentrate as claimed in any of claims 1 to 4, wherein the n-alkanoic acid and/or its salts has/have 8 to 12 carbon atoms.

6. A developer concentrate as claimed in any of claims 1 to 5, wherein the content of n-alkanoic acid in the concentrate is 1.5 to 14.0 % by weight.

7. A developer concentrate as claimed in any of claims 1 to 6, wherein the n-alkanoic acid and/or its salts are selected from the group comprising caprylic, pelargonic, capric and lauric acid.

8. A developer concentrate as claimed in any of claims 1 to 7, wherein the content of anionic surfactant in the concentrate is 1.0 to 8.0 % by weight.

9. A developer concentrate as claimed in any of claims 1 to 8, wherein at least one anionic surfactant is selected from the group comprising alkali-metal, preferably sodium, octyl sulfate, dodecylbenzenesulfonate, alkyl phenol ether sulfates, naphthalenesulfonates, sulfosuccinates, alkyl ether phosphates or alkali-metal, preferably sodium oleic acid methyl tauride.

10. A developer concentrate as claimed in any of claims 1 to 9, wherein the content of emulsifier in the concentrate is 0.2 to 6.0 % by weight.

11. A developer concentrate as claimed in any of claims 1 to 10, wherein at least one emulsifier is selected from the group comprising poly-N-vinyl-N-methylacetamide, water soluble copolymers of N-vinyl-N-methylacetamide, polyvinyl alcohol, dextrin, gum arabic and cellulose ethers, in particular carboxymethyl cellulose.

12. A developer concentrate as claimed in any of claims 1 to 11, wherein the content of organic solvent in the concentrate is 1.0 to 10.0 % by weight.

13. A developer concentrate as claimed in any of claims 1 to 12, wherein at least one organic solvent is selected from the group comprising benzyl alcohol, phenoxyethanol, 1-phenylethanol, 2-phenylethanol and propylene glycol monomethyl and -phenyl ether.

14. A developer concentrate as claimed in any of claims 1 to 13, wherein the content of buffering substance in the concentrate is 0.7 to 10.0 % by weight.

15. A developer concentrate as claimed in any of claims 1 to 14, wherein the buffering substance is selected from the group comprising carbonates, phosphates, borates, alkali-metal salts of glycine and amines, preferably diethanolamine and triethanolamine.

16. A process for preparing a printing form which comprises applying a negative-working reproduction layer containing diazonium salt polycondensation resin to a base, exposing the layer imagewise and then developing it with a developer prepared by dilution from the concentrate as claimed in any of claims 1 to 15.

17. A process for producing a printing form which comprises applying a negative-working reproduction layer containing a photopolymerizable compound to a base, exposing the layer imagewise and then developing it with a developer prepared by dilution from the concentrate as claimed in any of claims 1 to 15.

18. A process for producing a printing form, which comprises applying a negative-working reproduction layer containing both a diazonium salt polycondensation resin and a photopolymerizable compound to a base and proceeding further as claimed in claim 16.

## Revendications

1. Concentré de révélateur, consistant en un mélange d'eau,
de 1,0 à 15% en poids d'un solvant organique,
de 1,5 à 8,0% en poids d'un hydroxyde de métal alcalin,
de 1,0 à 15% en poids d'un dérivé tensioactif anionique,
de 1,0 à 16% en poids d'un acide n-alcanoïque et/ou de ses sels,
de 0,1 à 10% en poids d'un agent émulsionnant,
de 0,5 à 20% en poids d'une substance tampon et
de 0,5 à 9,0% en poids d'un complexant qui est un sel alcalin d'un phosphate oligomère avec de 2 à 10 motifs phosphore et/ou de l'acide N-(2-hydroxy-éthyl)-éthylènediaminetriacétique,
que l'on peut diluer avec de l'eau courante dans le rapport 1:0,5 à 1:3 pour obtenir un révélateur de développement d'une couche de reproduction exposée travaillant en négatif appliquée sur un support.

2. Concentré de révélateur selon la revendication 1, caractérisé en ce que, la teneur en complexant dans le concentré est de 0,5 à 6% en poids.

3. Concentré de révélateur selon la revendication 1 ou 2, caractérisé en ce que, le complexant est le sel alcalin d'un oligophosphate avec 2 à 6 motifs phosphore.

4. Concentré de révélateur selon la revendication 1 ou 2, caractérisé en ce que, le complexant est le sel de sodium de l'acide N-(2-hydroxyéthyl)éthylènediaminetriacétique.

5. Concentré de révélateur selon l'une des revendications 1 à 4, caractérisé en ce que, l'acide n-alconoïque et/ou des sels de celui-ci présente/présentent 8 à 12 atomes de carbone.

6. Concentré de révélateur selon l'une des revendications 1 à 5, caractérisé en ce que, la teneur en acide n-alcanoïque est de 1,5 à 14,0% en poids dans le concentré.

7. Concentré de révélateur selon l'une des revendications 1 à 6, caractérisé en ce que, l'acide n-alcanoïque et/ou des sels de celui-ci sont choisis dans le groupe des acides caprylique, pélargonique, caprique et laurique.

8. Concentré de révélateur selon l'une des revendications 1 à 7, caractérisé en ce que, la teneur en dérivé tensioactif anionique est de 1,0 à 8,0% en poids dans le concentré.

9. Concentré de révélateur selon l'une des revendications 1 à 8, caractérisé en ce que, au moins un agent tensioactif anionique est choisi parmi le groupe des octylsulfates, des dodécylbenzosulfonates, des alkylphénoléthersulfates, des naphtalènesulfonates, des sulfosuccinates, des alkylétherphosphates alcalins, de préférence de sodium, ou un oléylméthyltauride alcalin, de préférence de sodium.

10. Concentré de révélateur selon l'une des revendications 1 à 9, caractérisé en ce que, la teneur en agent émulsionnant est de 0,2 à 6,0% en poids dans le concentré.

11. Concentré de révélateur selon l'une des revendications 1 à 10, caractérisé en ce que, au moins un agent émulsionnant est choisi parmi le groupe du poly-N-vinyl-N-méthylacétamide, des copolymères hydrosolubles du N-vinyl-N-méthylacétamide, de l'alcool polyvinylique, de la dextrine, de la gomme arabique, et de l'éther de cellulose, en particulier la carboxyméthylcellulose.

12. Concentré de révélateur selon l'une des revendications 1 à 11, caractérisé en ce que, la teneur en solvant organique est de 1,0 à 10,0% en poids dans le concentré.

13. Concentré de révélateur selon l'une des revendications 1 à 12, caractérisé en ce que, au moins un solvant organique est choisi parmi le groupe de l'alcool benzylique, du phénoxyéthanol, du 1-phényléthanol, du 2-phényléthanol et de l'éther monométhylique et phénylique de propylèneglycol.

14. Concentré de révélateur selon l'une des revendications 1 à 13, caractérisé en ce que, la teneur en substance tampon est de 0,7 à 10,0% en poids dans le concentré.

15. Concentré de révélateur selon l'une des revendications 1 à 14, caractérisé en ce que, la substance tampon est choisie parmi le groupe des carbonates, phosphates, borates, des sels alcalins de la glycine et des amines, de préférence la diéthanolamine et la triéthanolamine.

16. Procédé de fabrication d'une plaque d'impression, dans lequel on applique sur un support une couche de reproduction travaillant en négatif, contenant une résine de polycondensation d'un sel de diazonium, on insole la couche pour former une image et on développe finalement avec un révélateur qui est fabriqué par dilution à partir du concentré selon l'une des revendications 1 à 15.

17. Procédé de fabrication d'une plaque d'impression, dans lequel on applique sur un support une couche de reproduction travaillant en négatif, contenant un composé photopolymérisable, on insole la couche selon une image et on développe finalement avec un révélateur qui est fabriqué par dilution à partir du concentré selon l'une des revendications 1 à 15.

18. Procédé de fabrication d'une plaque d'impression, dans lequel on applique sur un support une couche de reproduction travaillant en négatif, contenant non seulement une résine de polycondensation d'un sel de diazonium, mais encore un composé photopolymérisable et on poursuit la fabrication selon la revendication 16.
